(19) Europäisches Patentamt
European Patent Office
Office européen des brevets

(11) **EP 4 556 441 A1**

(12) **EUROPEAN PATENT APPLICATION**

(43) Date of publication:
**21.05.2025 Bulletin 2025/21**

(21) Application number: **23383157.7**

(22) Date of filing: **14.11.2023**

(51) International Patent Classification (IPC):
**C01B 32/162** (2017.01)    **C23C 16/26** (2006.01)

(52) Cooperative Patent Classification (CPC):
**C01B 32/162; C23C 16/26;** C01B 2202/08

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicant: **Universitat de Barcelona**
**08028 Barcelona (ES)**

(72) Inventors:
• **BERTRAN SERRA, Enric**
**08007 BARCELONA (ES)**
• **AMADE ROVIRA, Roger**
**08007 BARCELONA (ES)**
• **OSPINA OSPINA, Rogelio**
**Colombia (ES)**
• **CHAITOGLOU, Stefanos**
**08007 BARCELONA (ES)**

(74) Representative: **Balder IP Law, S.L.**
**Paseo de la Castellana 93**
**5ª planta**
**28046 Madrid (ES)**

(54) **METHOD FOR OBTAINING ALIGNED CARBON NANOTUBES BY USING CHEMICAL VAPOR DEPOSITION AND PRODUCT OBTAINED WITH THE METHOD**

(57)    Method for obtaining aligned carbon nanotubes (VACNTs) by using chemical vapor deposition, which comprises the following steps:
a) arranging a graphite felt (F) in a sputtering chamber (1);
b) applying an iron (Fe) layer to the graphite felt (F);
c) heating the sputtering chamber (1) such that it reaches a temperature around 800°C during a first predetermined time while injecting Ar and $H_2$;
d) growing carbon nanotubes (CNT) by adding to the gas flow acetylene ($C_2H_2$) or methane ($CH_4$) and water ($H_2O$) vapor flow dragged by an Ar flow.

EP 4 556 441 A1

## Description

## TECHNICAL FIELD

The present invention belongs to the specific sector of hybrid materials based on carbon nanotubes and destined to, among others, nanostructured electrodes, supercapacitors, electrical filters in high power networks, electromagnetic brakes in vehicles, Anode/-Cathode in (batteries and fuel cells), Sensors (in fluids), Catalysis and electro-catalysis, Thermal isolation, and more specifically it relates to a method based in growing nanotubes using chemical vapor deposition. In particular, it allows to obtain a new material with a singular morphology, formed for the combination of two allotropes of carbon, graphite felt and very long (in the range of 1 millimetre), dense, and aligned carbon nanotubes.

## STATE OF THE ART

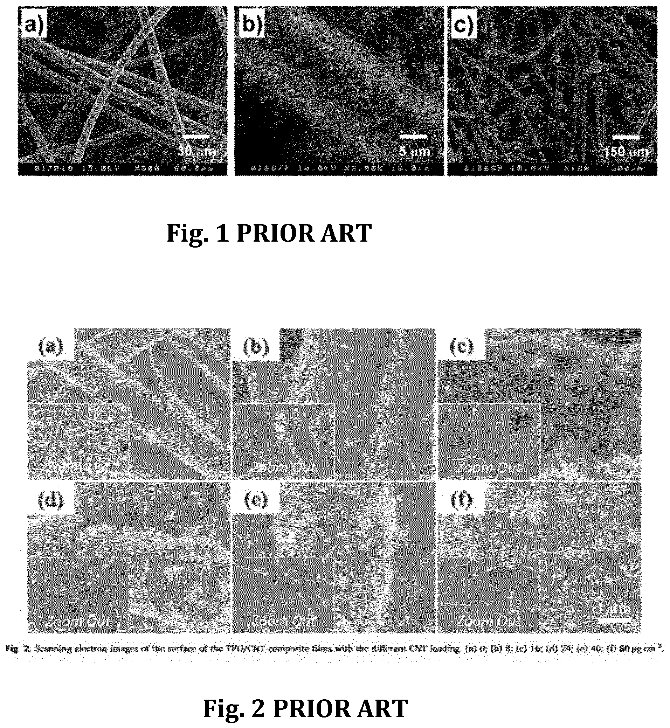

The 2011 document "Hierarchical micro/nano structures of carbon composites as anodes for microbial fuel cells" from Yong Zhao *et al.* discloses hierarchical structures consisting in carbon nanotubes (CNTs) directly grown on micro-porous graphite felts at high densities. This structure is shown in figure 1. The method disclosed by Yong Zhao *et al.* allows to obtain curly and short ($<5\mu m$) nanotubes around the felt fibers.

The 2018 document "Strain-gauge sensing composite films with self-restoring water-repellent properties for monitoring human movements" from Li, Z. *et al.* also discloses the growth of curly nanotubes on felts, but even shorter ($<3\mu m$). Figure 2 shows a micrograph thereof.

The inventors consider that these lengths of the nanotubes, as well as their arrangement, can be improved.

## DESCRIPTION OF THE INVENTION

For overcoming the state of the art limitations, the present invention proposes a method for obtaining aligned carbon nanotubes (CNT) by using chemical vapor deposition, which comprises the following steps:

a) arranging a graphite felt in a sputtering chamber and applying an aluminium layer on the graphite;
b) in the sputtering chamber, applying an iron (Fe) layer to the graphite felt;
c) placing the felt in a duct and heating the duct such that it reaches a temperature for cracking ($C_2H_2$) or methane ($CH_4$) during a first predetermined time while injecting Ar and $H_2$;
d) growing carbon nanotubes by adding to the gas flow acetylene ($C_2H_2$) or methane ($CH_4$) and water ($H_2O$) vapor flow dragged by an Ar mass flow,

wherein the mass flow of water is such that the $\phi H_2O =$ $k \cdot \phi Ar$, where $0.4\% < k < 12.5\%$.

This method allows to obtain extra-long nanotubes and ordered structures, and specifically

- Carbon nanotubes (CNTs) tested up to $900\mu m$;
- CNTs transversely aligned along the felt fibers;
- High surface density CNTs;
- With a robust anchor in the felt fiber.

In particular, on a homogeneous structure such as felt, structures made of very long and perfectly ordered nanotubes, in the form of feathers, can be achieved, which consists of a porous material with a very high active surface area.

In some embodiments, *k* is such that $2\% < k < 4\%$.

In some embodiments, in step c) Ar is injected at 125 sccm and $H_2$ is injected at 50 sccm and in step d) the gas flow acetylene ($C_2H_2$) or methane ($CH_4$) is injected at a mass flow of 50 sccm and water ($H_2O$) vapor flow dragged by an Ar mass flow of 0.5 sccm.

In some embodiments the method comprises a subsequent step of:
e) applying a surface finish by injecting Ar at 125 sccm and water vapor with argon ($H_2O$+Ar) at 0.5 sccm.

In some embodiments the method comprises a subsequent step of:
f) cooling by injecting dry Ar at 100 sccm for 1h.

In some embodiments the iron (Fe) layer has a thickness comprised between 1 and 7 nm.

In some embodiments the graphite felt has a density comprised between 0.050 and 0.100 $g/cm^3$.

In some embodiments the carbon fibers forming the graphite felt have a diameter comprised between 5 and 20 $\mu m$, more preferably between 8 and 12 $\mu m$.

Preferably the duct is made of quartz.

In some embodiments the pressure during the CNTs growth is comprised between 100 mbar and 1500 mbar, more preferably between 900 and 1100 mbar.

The invention also relates to a product comprising a graphite felt, wherein the carbon fibers of the felt are covered with an aluminium layer, iron nanoparticles and carbon nanotubes stemming from the nanoparticles.

Preferably the graphite felt has a density comprised between 0.050 and 0.100 $g/cm^3$ and the carbon fibers forming the graphite felt have a diameter comprised between 5 and 20 $\mu m$, more preferably between 8 and 12 $\mu m$.

Finally, the aluminium layer has a thickness comprised between 8 and 10 nm and the iron nanoparticles have a size of 5-20 nm.

## BRIEF DESCRIPTION OF THE DRAWINGS

To complete the description and in order to provide for a better understanding of the invention, a set of drawings is provided. Said drawings form an integral part of the description and illustrate an embodiment of the invention, which should not be interpreted as restricting the scope of the invention, but just as an example of how the invention can be carried out. The drawings comprise the following figures:

Figures 1 and 2 show nanotubes grown on felts following known methods.

Figure 3 shows the pretreatment applied to the graphite fiber.

Figure 4 shows the growth of the carbon nanotubes starting from the iron islands.

Figure 5 shows a detail of the reaction occurring at the growth end of the nanotube.

Figure 6 is a graph showing the growth rate of carbon nanotubes from acetylene (mass flow of 50 sccm) in presence of water vapor as a function of the water mass flow.

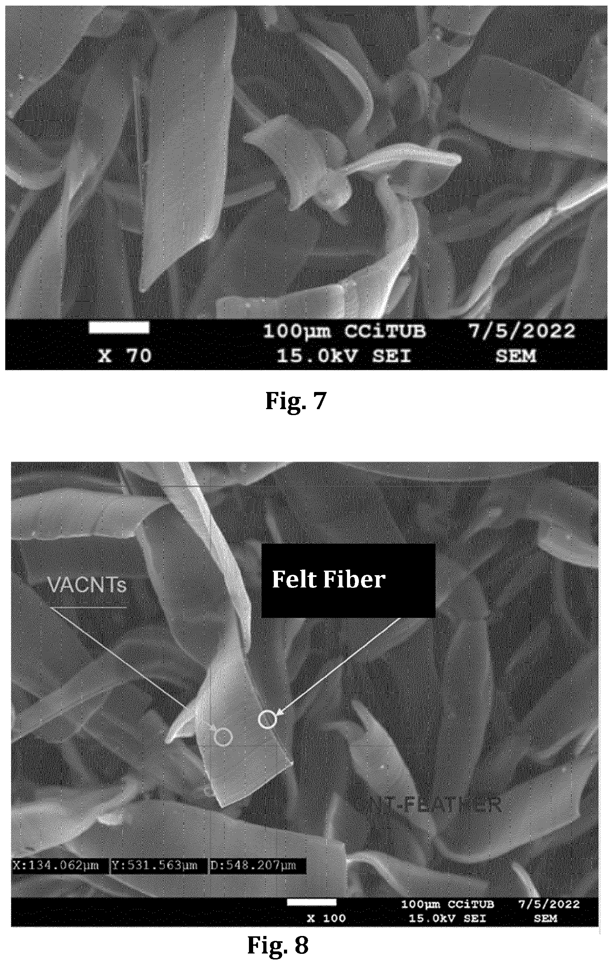

Figures 7 and 8 are micrographs showing the CNTs feathers produced following the inventive method. The morphology of the carbon nanotube feathers provides a transversal wide of around 5 microns (diameter of felt fibers), a length in the image of around 100 microns, which can reach a value in the order of 1 mm, depending on the growth time.

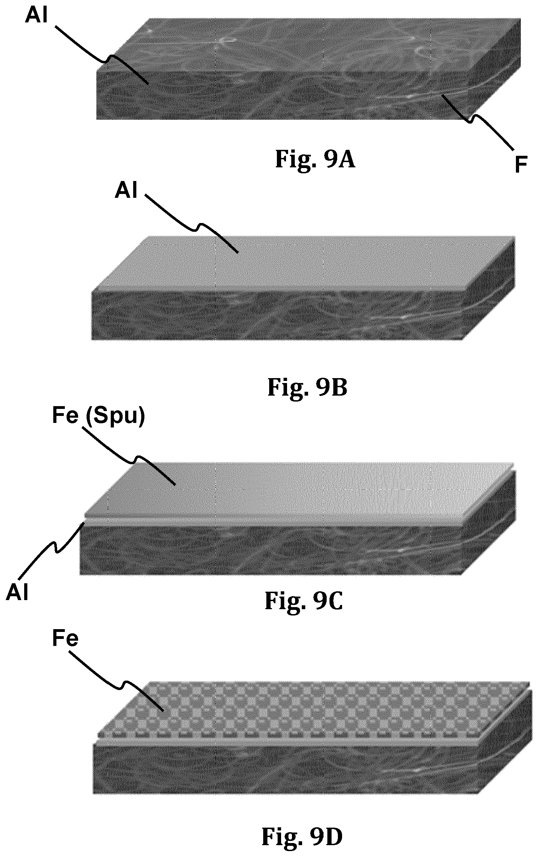

Figures 9A to 9D show the sub-steps allowing to obtain the Fe nanoislands having a size of 5-20 nm.

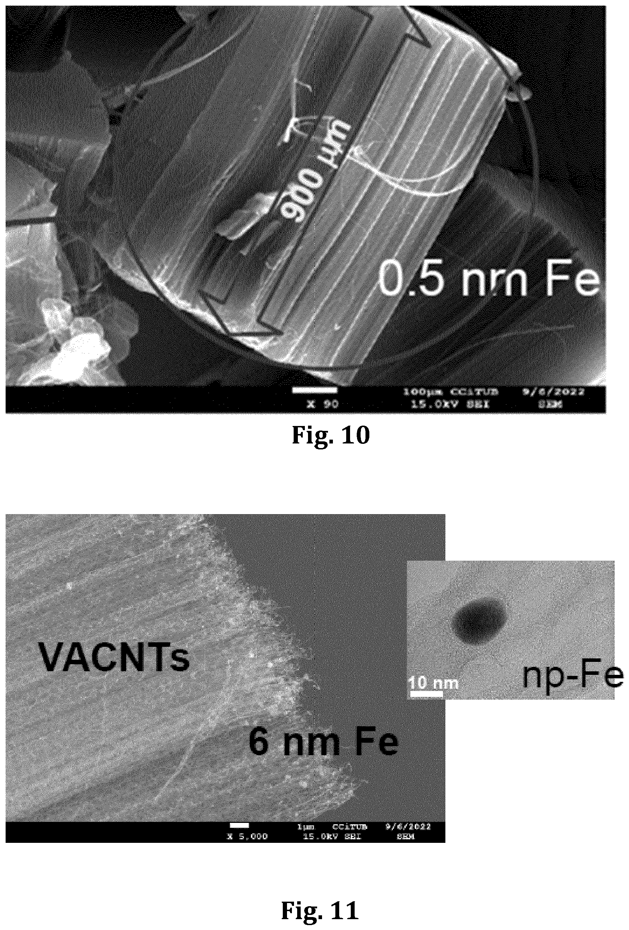

Figure 10 illustrates the measurement of the long nanotubes produced with the inventive method.

Figure 11 shows an image of the dense and aligned carbon nanotubes. The morphology of the carbon nanotube beam can be described by a surface density of $(5\times10^{17} \pm 9\times10^{16})$ m$^{-2}$, being the carbon nanotube beam anchored to the felt fibers, and having a transversal wide of around 5 microns (diameter of felt fiber), and a length of hundreds of microns.

Figure 12 shows an iron island into the tip of a carbon nanotube. The morphology of the carbon nanotubes is: diameter around 15 nm, multiwall (having between 3 and 10 monoatomic layers), length depending of the growing time (example in 10 min of growth the carbon nanotubes can reach around 900 microns).

Figure 13 shows the known relationship between the acetylene decomposition temperature and the carbon yield % over freshly reduced iron oxide with average crystal size 35 nm (taken from M.H. Khedr, K.S. Abdel Halim, N.K. Soliman, Effect of temperature on the kinetics of acetylene decomposition over reduced iron oxide catalyst for the production of carbon nanotubes, Applied Surface Science, Volume 255, Issue 5, Part 1, 2008, Pages 2375-2381, https://doi.org/10.1016/i.ap susc.2008.07.096).

Figure 14 shows the CH$_4$ equilibrium conversion at different temperatures [°C] and pressures [bar] calculated on Aspen Plus software v11 (by Aspen Tech) (Taken from Palo, E.; Cosentino, V.; Iaquaniello, G.; Piemonte, V.; Busillo, E. Thermal Methane Cracking on Molten Metal: Kinetics Modeling for Pilot Reactor Design. Processes 2023, 11, 1537. https://doi.org/10.3390/pr11051537)

## DESCRIPTION OF A WAY OF CARRYING OUT THE INVENTION

According to a preferred embodiment the method for obtaining aligned carbon nanotubes (CNT) by using chemical vapor deposition according to the invention comprises the following steps:

a) arranging a graphite felt F in a sputtering chamber 1 and applying an aluminium layer on the graphite

According to this embodiment the graphite felt F has a density of 0.075 g/cm$^3$. This density corresponds to a porosity of 96.7% defined as the $V_{void}/V_{total}$, and considering a graphite density of 2.26 g/cm$^3$.
Here a 10 nm (aprox.) Aluminium layer is applied on the carbon fibers of the felt F by sputtering; this layer is aimed at preventing the next Fe layer to be applied from being absorbed into the graphite;

b) applying an iron (Fe) layer to the graphite felt F

In this step a 3 nm iron layer (Fe) is applied, again by sputtering. The sample is heated around 800°C, the iron film undergoes a transformation, turning into iron nanoparticles on the aluminium film.

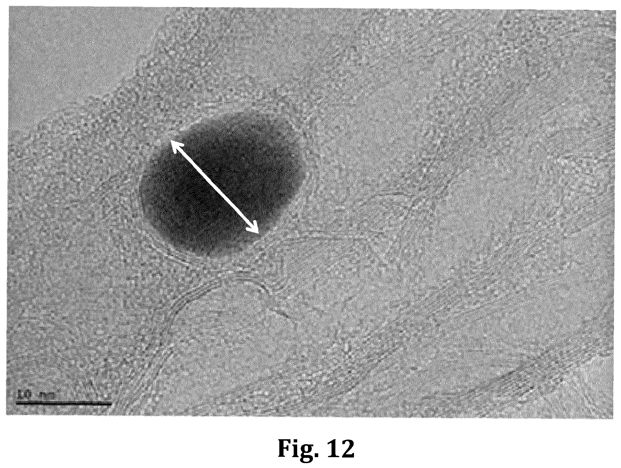

Figure 12 shows a micrograph showing an iron nanoparticle. The arrow corresponds to 13.3 nm.

c) Placing the felt in a duct and heating

The duct is heated such that it reaches a temperature high enough for cracking (C$_2$H$_2$) or methane (CH$_4$) during a first predetermined time while injecting Ar preferably at 125 sccm and H$_2$ at 50 sccm (Here, it should be clear that there is still neither methane nor acetylene in the tube. This stage with argon and hydrogen is used solely to heat the sample - which already has the iron nanolayer- in order to reach the cracking temperature, preventing the iron from oxidizing with the residual oxygen that might be present inside the tube coming from to the atmosphere when it was opened to place the sample.);

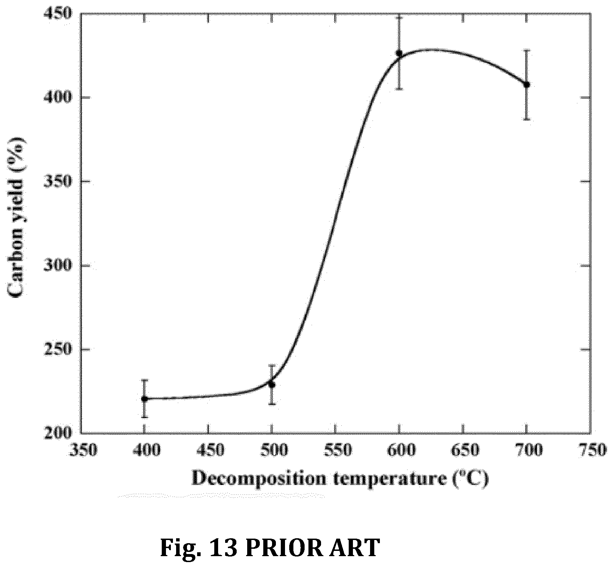

In the case of acetylene and as shown in Fig. 13, the thermal cracking theoretically occurs at temperatures above 305°C and according to Khedr et al. (2008), the catalytic decomposition of acetylene in the presence of iron oxide ($Fe_2O_3$) nanoparticles takes place within the temperature range of 400°C to 700°C.

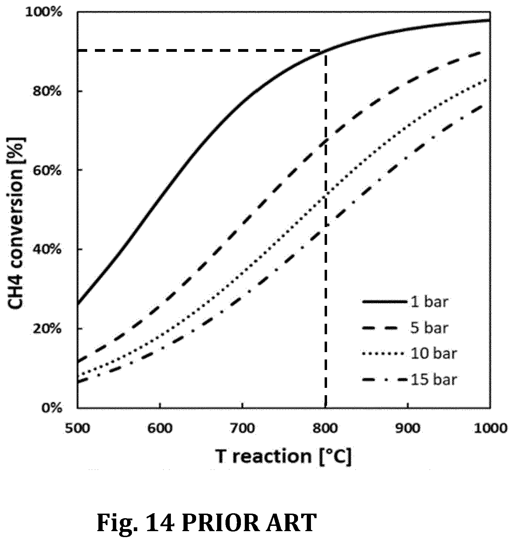

In the case of methane, as shown in Fig. 14, according to Palo et al. (2023), the thermal decomposition of methane theoretically begins above 300°C, with 90% decomposition of $CH_4$ occurring at 800°C.

d) growing carbon nanotubes

The growth of the carbon nanotubes (CNT) is carried out by adding to the gas flow methane $CH_4$ or acetylene at a mass flow of 50 sccm and water $H_2O$ vapor flow dragged by an Ar mass flow of 0.5 sccm, with such that the $\phi_{H2O} = k \cdot \phi_{Ar}$. The pressure during the CNTs growth was aprox. 1000 mbar. The water dosage is carried out preferably by bubbling argon in a Dreschel type vessel of deionized water, such that:

$$\phi_{H2O} = 3.2 \times 10^{-2} \cdot \phi_{Ar}$$

That is the mass flow of water is 3.2% of the argon mass flow.

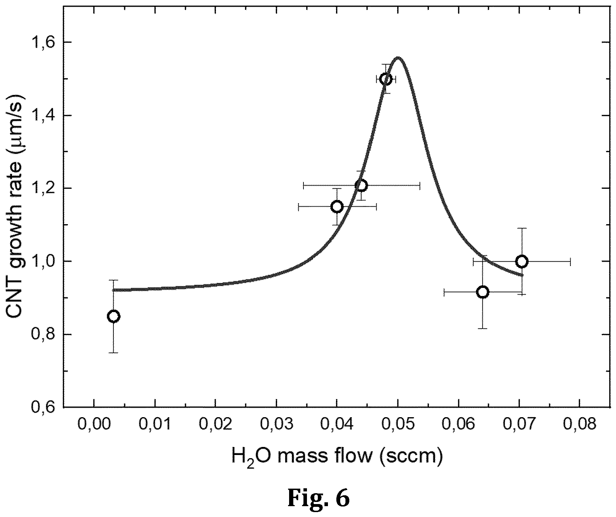

The mass flow of water plasma is a consequence of the dragging effect of Ar gas passing through a Dreschel vessel with saturated water vapor. As shown in figure 6, the fraction of partial pressure of water vapor at 25° C of temperature is a 3.2% of the total pressure inside the vessel (Ar + $H_2O$ vapor). For example, having a 0.5 sccm of mass flow of Ar passing through the Dreschel vessel, a 0.016 sccm of water vapor mass flow will be obtained. The maximum of CNTs growth rate is at 1.5 sccm of mass flow of argon that corresponds to a water vapor dragged of 0.05 sccm.

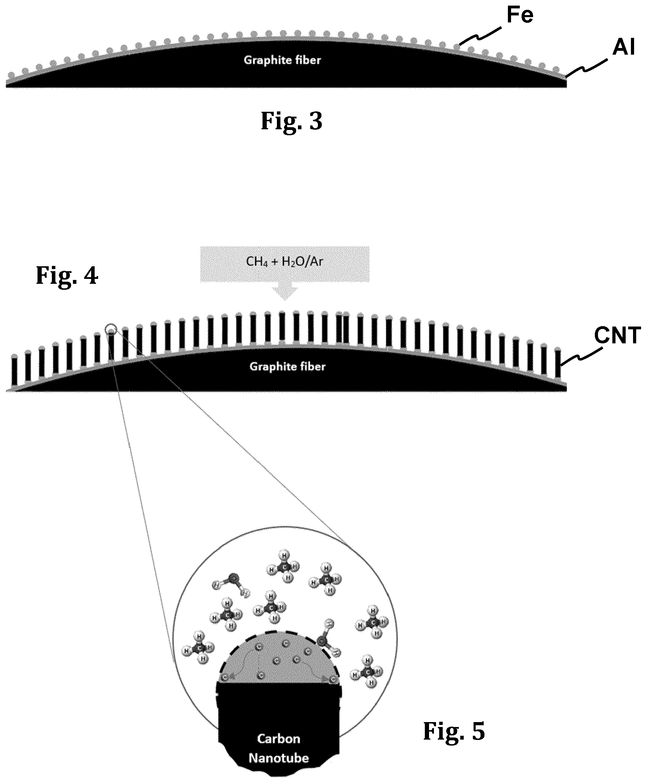

Figures 4 and 5 show the growth process:
First, the Fe nanoparticle is part of the CNT growth mechanism based on the dissolution at 800°C of the carbon species that arrive from the gas phase. The dissolution is followed by a process of segregation of carbon atoms from the interior of the iron nanoparticle, which occurs when supersaturation of the carbon dissolved in the iron nanoparticle is reached. The segregated carbon atoms are deposited in an orderly manner, giving rise to the formation of the walls of the CNTs, which are composed by cylindrical graphene layers.

The gas phase comprises water, hydrogen, and carbon precursor (methane, acetylene) molecules, along with various radicals stemming from these molecules.

The water molecules play a crucial role in cleaning the surface of iron nanoparticles, continually eliminating the amorphous carbon film that tends to form on them. There is an optimal mass flow ratio, preferably $\phi_{H2O} = k'\phi_{CH4}$, with $k'$ around $10^{-3}$:

- An excess of water on the surface hinders the diffusion of carbon from the gas phase (from the methane) to the iron nanoparticle. Consequently, this impedes the growth rate of carbon nanotubes (CNTs).

- Conversely, a low concentration of water in the gas phase proves insufficient to adequately clean the surface of iron nanoparticles. This results in the formation of an amorphous carbon layer, which blocks the diffusion of carbon adatoms inside the iron nanoparticle, leading to a reduction in the growth rate of CNTs.

Subsequent steps

Then, subsequent steps are applied consisting in:

e) applying a surface finish by injecting Ar at 125 sccm;
g) cooling by injecting Ar at 100 sccm for 1h.

As disclosed, in the experimental setups used in the embodiments of the invention, carbon nanotubes are grown within a quartz tube using either methane or acetylene at atmospheric pressure, and a very low concentration of water molecules as described before.

A piece of graphite felt, with nanoparticles of iron as catalyst, is positioned in the central zone of a tubular oven, which is concentric with the quartz tube. The gas (methane or acetylene) is introduced into the tube at a mass flow rate of 50 sccm. Considering the 40 mm diameter of the quartz tube, the gas flows over the graphite felt at a velocity of 4 cm/min. With the initial gas temperature set at room temperature (25°C) and the oven's total length at 35 cm, with a central 10 cm segment maintained at 800°C, the residence time of the gas inside the oven is approximately 9 minutes. The temperature ramps up from 25°C to 800°C within 3 minutes, followed by a residence time at 800°C of 2.5 minutes.

It's important to note that this kinetic setup may not guarantee that the gas (either methane or acetylene) reaches 800°C when passing over the sample. Even though the gas decomposition might not be complete, it suffices to achieve a very high growth rate of carbon nanotubes.

In this text, the term "comprises" and its derivations (such as "comprising", etc.) should not be understood in an excluding sense, that is, these terms should not be interpreted as excluding the possibility that what is described and defined may include further elements, steps, etc.

The invention is obviously not limited to the specific embodiment(s) described herein, but also encompasses any variations that may be considered by any person skilled in the art (for example, as regards the choice of materials, dimensions, components, configuration, etc.), within the general scope of the invention as defined in the claims.

**Claims**

1. Method for obtaining aligned carbon nanotubes (VACNTs) by using chemical vapor deposition, which comprises the following steps:

   a) arranging a graphite felt (F) in a sputtering chamber and applying an aluminium layer (Al);
   b) in the sputtering chamber applying an iron (Fe) layer to the graphite felt (F);
   c) placing the felt (F) in a duct and heating the duct such that it reaches a temperature for cracking ($C_2H_2$) or methane ($CH_4$) during a first predetermined time while injecting Ar and $H_2$;
   d) growing carbon nanotubes (CNT) by adding to the gas flow acetylene ($C_2H_2$) or methane ($CH_4$) and water ($H_2O$) vapor flow dragged by an Ar flow,

   the mass flow of water being such that the $\phi_{H2O} = k \cdot \phi_{Ar}$, where $0.4\% < k < 12.5\%$.

2. Method according to claim 1, wherein $2\% < k < 4\%$.

3. Method according to any of the preceding claims wherein in step c) Ar is injected at 125 sccm and $H_2$ is injected at 50 sccm and in step d) the gas flow acetylene ($C_2H_2$) or methane ($CH_4$) is injected at a mass flow of 50 sccm and water ($H_2O$) vapor flow dragged by an Ar mass flow of 0.5 sccm.

4. Method according to any of the preceding claims which comprises a subsequent step of: e) applying a surface finish by injecting Ar at 125 sccm and water ($H_2O$) at 0.5 sccm.

5. Method according to any of the preceding claims which comprises a subsequent step of: f) cooling by injecting Ar at 100 sccm for 1h.

6. Method according to any of the preceding claims wherein the aluminium layer has a thickness comprised between 8 and 10 nm.

7. Method according to any of the preceding claims, wherein the iron (Fe) layer has a thickness comprised between 1 and 7 nm.

8. Method according to any of the preceding claims, the graphite felt (F) has a density comprised between 0.050 and 0.100 g/cm$^3$.

9. Method according to any of the preceding claims, wherein the carbon fibers forming the graphite felt (F) have a diameter comprised between 5 and 20 $\mu$m, more preferably between 8 and 12 $\mu$m.

10. Method according to any of the preceding claims, wherein the duct (1) is made of quartz.

11. Method according to any of the preceding claims, wherein the pressure during the CNTs growth is comprised between 100 mbar and 1500 mbar, more preferably between 900 and 1100 mbar.

12. Method according to any of the preceding claims, wherein in step d) the dosage of water is carried out by bubbling argon in water, preferably in a Dreschel type vessel.

13. Product comprising a graphite felt (F), wherein the carbon fibers of the felt (F) are covered with an aluminium layer (Al), iron nanoparticles (Fe), and carbon nanotubes (CNT) stemming from the nanoparticles (Fe).

14. Product according to claim 13, wherein the graphite felt (F) has a density comprised between 0.050 and 0.100 g/cm$^3$ and the carbon fibers forming the graphite felt (F) have a diameter comprised between 5 and 20 $\mu$m, more preferably between 8 and 12 $\mu$m and wherein the Aluminium layer has a thickness comprised between 8 and 10 nm and the iron nanoparticles have a size of 5-20 nm.

15. Product according to any of claims 13 or 14 obtained with the method according to any of claims 1 to 12.

**Fig. 1 PRIOR ART**

Fig. 2. Scanning electron images of the surface of the TPU/CNT composite films with the different CNT loading. (a) 0; (b) 8; (c) 16; (d) 24; (e) 40; (f) 80 μg cm$^{-2}$.

**Fig. 2 PRIOR ART**

**Fig. 3**

**Fig. 4**

CH₄ + H₂O/Ar

CNT

Graphite fiber

Carbon
Nanotube

**Fig. 5**

**Fig. 6**

Fig. 7

Fig. 8

**Al**

**Fig. 9A**

**F**

**Al**

**Fig. 9B**

**Fe (Spu)**

**Al**

**Fig. 9C**

**Fe**

**Fig. 9D**

**Fig. 10**

**Fig. 11**

**Fig. 12**

**Fig. 13 PRIOR ART**

**Fig. 14 PRIOR ART**

Europäisches
Patentamt

European
Patent Office

Office européen
des brevets

# EUROPEAN SEARCH REPORT

**Application Number**

**EP 23 38 3157**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | CUONG PHAM-HUU ET AL: "Carbon nanomaterials with controlled macroscopic shapes as new catalytic materials", TOPICS IN CATALYSIS, KLUWER ACADEMIC PUBLISHERS-PLENUM PUBLISHERS, NE, vol. 40, no. 1-4, 1 November 2006 (2006-11-01), pages 49-63, XP019454942, ISSN: 1572-9028, DOI: 10.1007/S11244-006-0104-8 * page 50, right-hand column, paragraph 3 - page 55, right-hand column, paragraph 1 * ----- | 1-15 | INV. C01B32/162 C23C16/26 |
| A | WANG K ET AL: "Catalytic synthesis of a high aspect ratio carbon nanotubes bridging carbon felt composite with improved electrical conductivity and effective surface area", APPLIED CATALYSIS A: GENERAL, ELSEVIER, AMSTERDAM, NL, vol. 392, no. 1-2, 29 January 2011 (2011-01-29), pages 238-247, XP027593643, ISSN: 0926-860X, DOI: 10.1016/J.APCATA.2010.11.014 [retrieved on 2011-01-07] * page 239, left-hand column, paragraph 3 - right-hand column, paragraph 4 * ----- -/-- | 1-15 | TECHNICAL FIELDS SEARCHED (IPC) C01B C23C |

The present search report has been drawn up for all claims

| Place of search | Date of completion of the search | Examiner |
|---|---|---|
| The Hague | 5 April 2024 | Sevillano Rodriguez |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**page 1 of 2**

Europäisches
Patentamt

European
Patent Office

Office européen
des brevets

# EUROPEAN SEARCH REPORT

Application Number

**EP 23 38 3157**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | SHANKHAMALA KUNDU ET AL: "Synthesis of an improved hierarchical carbon-fiber composite as a catalyst support for platinum and its application in electrocatalysis", CARBON, ELSEVIER OXFORD, GB, vol. 50, no. 12, 16 May 2012 (2012-05-16), pages 4534-4542, XP028403918, ISSN: 0008-6223, DOI: 10.1016/J.CARBON.2012.05.037 [retrieved on 2012-05-23] * page 4535, right-hand column, paragraph 2 - paragraph 4 * | 1-15 | |
| A | WENYUE LI ET AL: "Multi-walled carbon nanotubes used as an electrode reaction catalyst for /VO2+ for a vanadium redox flow battery", CARBON, vol. 49, no. 11, 1 September 2011 (2011-09-01), pages 3463-3470, XP055114081, ISSN: 0008-6223, DOI: 10.1016/j.carbon.2011.04.045 * page 3464, right-hand column, paragraph 1 * | 1-15 | TECHNICAL FIELDS SEARCHED (IPC) |

The present search report has been drawn up for all claims

| Place of search | Date of completion of the search | Examiner |
|---|---|---|
| The Hague | 5 April 2024 | Sevillano Rodriguez |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **2011** ; **YONG ZHAO**. *Hierarchical micro/nano structures of carbon composites as anodes for microbial fuel cells*
- **LI, Z.** *Strain-gauge sensoring composite films with self-restoring water-repellent properties for monitoring human movements*, 2018
- **M.H. KHEDR** ; **K.S. ABDEL HALIM** ; **N.K. SOLIMAN**. Effect of temperature on the kinetics of acetylene decomposition over reduced iron oxide catalyst for the production of carbon nanotubes. *Applied Surface Science*, 2008, vol. 255 (5), 2375-2381, https://doi.org/10.1016/i.apsusc.2008.07.096
- **PALO, E.** ; **COSENTINO, V.** ; **LAQUANIELLO, G.** ; **PIEMONTE, V.** ; **BUSILLO, E.** Thermal Methane Cracking on Molten Metal: Kinetics Modeling for Pilot Reactor Design. *Processes*, 2023, vol. 11, 1537, https://doi.org/10.3390/pr11051537